# EUROPÄISCHE PATENTSCHRIFT

(11) **EP 3 805 771 B1**
(45) Veröffentlichungstag und Bekanntmachung des Hinweises auf die Patenterteilung: **08.01.2025**
(21) Anmeldenummer: 20201084.9
(22) Anmeldetag: 09.10.2020
(51) Int. Cl.: G01R 33/28, G01R 33/385, G01R 33/3875, H01F 41/06, H01F 5/00

(54) **GRADIENTENSPULE FÜR EIN MRT-GERÄT**
GRADIENT COIL FOR AN MRI DEVICE
BOBINE DE GRADIENT POUR APPAREIL IRM

(30) Priorität: 11.10.2019 DE 102019127466
(43) Veröffentlichungstag der Anmeldung: 14.04.2021
(73) Patentinhaber: Albert-Ludwigs-Universität Freiburg, 79098 Freiburg (DE)
(72) Erfinder: LITTIN, Sebastian, 79115 Freiburg (DE); ZAITSEV, Maxim, 79117 Freiburg (DE); JIA, Feng, 79115 Freiburg (DE); AMREIN, Philipp, 79110 Freiburg (DE)
(74) Vertreter: Mertzlufft-Paufler, Cornelius

(56) Entgegenhaltungen:
- US-A1- 2006 113 996
- US-A1- 2012 074 942
- INTERNATIONAL SOCIETY FOR MAGNETIC RESONANCE IN MEDICINE, ISMRM, 2030 ADDISON STREET, 7TH FLOOR, BERKELEY, CA 94704 USA, no. 109, 26 April 2019 (2019-04-26), XP040707496

## Beschreibung

Die Erfindung betrifft eine Magnetspule für ein MR-Gerät oder für einen Magnetpartikelbildgebungstomographen mit einem ersten Leiterabschnitt und einem seriell an den ersten Leiterabschnitt anschließenden zweiten Leiterabschnitt, wobei der erste Leiterabschnitt und der zweite Leiterabschnitt jeweils eine Mehrzahl von Windungen aufweisen.

Bei der Magnetspule handelt es sich bevorzugt um eine Niederfrequenzspule wie insbesondere um eine Gradientenspule und/oder um eine Shimspule.

Derartige Magnetspulen werden in der Praxis standardmäßig als Gradientenspule unter anderem zur Ortskodierung von MR-Signalen in MRT-Geräten verwendet. Gradientenspulen werden unter anderem auch zur Signalpräparation, die beispielsweise bei der diffusionsgewichteten Bildgebung erforderlich ist, in MRT-Geräten verwendet. Beispielsweise werden zur Erzeugung linear variierender Gradientenfelder Spulen mit spiralförmigen Wicklungen zur Erzeugung der X- und Y-Gradienten verwendet und Spulen mit schraubenförmiger Wicklung zur Erzeugung eines Z-Gradienten. Derartige Spulen werden daher auch als X-, Y- und Z-Gradientenspulen bezeichnet. Shimspulen werden in der Praxis zur Homogenisierung eines Hauptmagnetfeldes eines MR-Geräts verwendet. Dieser Vorgang wird auch als Shimming bezeichnet. Shimspulen können Ordnungen verschiedener Größe aufweisen, typischerweise bis zur dritten Ordnung. Die erste Ordnung wird regelmäßig von den Gradientenspulen übernommen, sodass die Shimspulen typischerweise quadratisch oder kubisch variierende Magnetfelder aufweisen. Gradienten- und/oder Shimspulen können allerdings je nach Ausgestaltung auch beliebige im Raum variierende Feldgeometrien annehmen. Gradientenspulen und Shimspulen erzeugen gleichsam magnetische, im Raum variierende Gradientenfelder.

Im Rahmen dieser Erfindung wird die Abkürzung MR verwendet, um den Begriff "Magnetresonanz" abzukürzen. Die Abkürzung MRT wird verwendet, um den Begriff "Magnetresonanztomographie" abzukürzen.

Es besteht ein Bedürfnis danach, die mittels einer Magnetspule eines MR-Geräts oder eines Magnetpartikelbildgebungstomographen durchführbare Ortskodierung und/oder Signalpräparation zu beschleunigen, da hierdurch einerseits Kosten gespart werden können und andererseits die in einer bestimmten Zeitspanne messbare Informationsmenge über ein Messobjekt erhöht werden kann.

Die Ortskodierung und die Signalpräparation wird insbesondere dann beschleunigt, wenn die Ströme, mit denen die Magnetspule betrieben wird, erhöht werden und/oder wenn diese Ströme schneller geschaltet werden. Dies hat für viele Anwendungen Vorteile, beispielsweise profitiert infolge der beschleunigten Signalpräparation auch die diffusionsgewichtete Bildgebung.

Begrenzt wird diese Strategie unter anderem dadurch, dass es hierdurch zu einer Stimulation peripherer Nerven von Probanden kommen kann.

US 2012/0074942A1 offenbart eine Gradientenspule für einen Magnetresonanztomographen. Die Gradientenspule weist eine Korrekturspule auf, die teilweise in die Hauptwicklung eingewickelt ist, wobei die Korrekturspule und die Hauptwicklung jeweils über einen Switch ansteuerbar sind.

US 2006/0113996A1 offenbart eine doppellagige Gradientenspule, wobei eine erste Wicklungslage auf einer Seite einer Isolierschicht angeordnet ist und wobei eine zweite, mit der ersten Wicklungslage elektrisch verbundene Wicklungslage auf der anderen Seite der Isolierschicht angeordnet ist.

Der Erfindung liegt die Aufgabe zugrunde, die mit einer Magnetspule erzielbare Ortskodierung und/oder Signalpräparation zu beschleunigen.

Zur Lösung dieser Aufgabe schlägt die Erfindung die Merkmale von Anspruch 1 vor. Insbesondere wird somit erfindungsgemäß bei einer Magnetspule der eingangs beschriebenen Art zur Lösung der genannten Aufgabe vorgeschlagen, dass mindestens eine Windung des ersten Leiterabschnitts zwischen zwei benachbarten Windungen des zweiten Leiterabschnitts angeordnet ist. Bevorzugt sind mehrere, nahezu alle oder sogar alle Windungen des ersten Leiterabschnitts jeweils zwischen zwei benachbarten Windungen des zweiten Leiterabschnitts angeordnet.

Die zuvor genannte Aufgabe wird auch durch ein MR-Gerät gelöst, welches eine Magnetspule nach einem der auf eine solche gerichteten Ansprüche umfasst. Gleichsam wird die genannte Aufgabe durch ein Magnetpartikelbildgebungstomographen gelöst, welcher eine erfindungsgemäß ausgebildete Magnetspule aufweist.

Eine Gradientenspule wird bei der Magnetpartikelbildgebung häufig auch als Selektionsspule bezeichnet. Da diese analog zu einer Gradientenspule bei einem MRT-Gerät für die Ortskodierung zuständig ist, wird im Rahmen dieser Erfindung gleichsam von einer Gradientenspule gesprochen.

Durch die vorgeschlagenen Lösungen der Aufgabe kann erreicht werden, dass die Schwelle, bei der eine Stimulation peripheren Nerven auftritt, nach oben verschoben wird, so dass höhere Schaltzeiten der Magnetspule erreichbar sind und/oder die Magnetspule mit stärkeren Strömen betreibar ist.

Es hat sich nämlich herausgestellt, dass eine Stimulation peripherer Nerven nicht nur von dem von der Magnetspule erzeugten Magnetfeld verursacht wird, sondern auch von dem von der Magnetspule erzeugten elektrischen Feld. Hierbei ist neben dem elektrischen Feld, welches als Begleiterscheinung zu dem zeitlich variierenden Magnetfeld auftritt, auch das konservative elektrische Feld von entscheidender Bedeutung. Das konservative elektrische Feld hängt von der Spannungsverteilung der Spulenwindungen ab.

Im Rahmen dieser Erfindung wurde erkannt, dass die Umordnung von Spulenwindungen bei serieller Verschaltung zwar das von diesen erzeugte Magnetfeld im Wesentlichen unberührt lässt, die Umordnung allerdings zugleich einen erheblichen Einfluss auf das von der Magnetspule erzeugte konservative elektrische Feld hat. So kann die Spulenumordnung beispielsweise dazu führen, dass hohe Spannungsdifferenzen räumlich nah beieinander liegen, so dass es zu einer Feldauslöschung und somit zu einem reduzierten effektiven elektrischen Feld bereits bei Distanzen kommt, welche den Abstand von zwei benachbarten Windungen überschreitet. Da das Messvolumen regelmäßig diese Distanzen überschreitet, ist die Gefahr einer Stimulation peripherer Nerven reduziert.

Herkömmlicherweise wird eine Spule derart gewickelt, dass serielle Leiterabschnitte spiralförmig-fortlaufend oder helikal-fortlaufend und nicht-überlappend gewickelt werden, so dass Windungen von voneinander anschließenden Leiterabschnitten nicht ineinandergreifen. Dies ist bei der vorliegenden Erfindung anders, bei der mindestens eine Windung eines ersten Leiterabschnitts zwischen zwei benachbarten Windungen eines zweiten, sich an den ersten Leiterabschnitt anschließenden Leiterabschnitts angeordnet ist.

Eine Windung eines Leiterabschnitts kann dadurch charakterisiert sein, dass sie durch einen umlaufenden Teilabschnitt des Leiterabschnitts gegeben ist. Eine Windung kann beispielsweise durch eine schraubenförmige Umrundung einer Mantelfläche wie etwa einer zylinderförmigen Mantelfläche gegeben seien. Ferner kann eine Windung beispielsweise auch durch eine Umrundung eines Punktes auf einer Mantelfläche gegeben sein wie beispielsweise eine spiralförmig verlaufende Umrundung eines derartigen Punktes auf einer beispielsweise zylinderförmigen oder ebenen Mantelfläche.

Der erste Leiterabschnitt und der zweite Leiterabschnitt bilden Abschnitte eines Leiters. Der Leiter ist vorzugsweise verzweigt. Vorzugsweise ist der Leiter durch einen Draht gegeben. Der Draht kann dabei eine oder mehrere Litzen aufweisen.

Besonders schnelle Schaltzeiten können bei einer vorteilhaften Ausgestaltung der Magnetspule erreicht werden, bei der vorgesehen ist, dass Windungen des ersten Leiterabschnitts und Windungen des zweiten Leiterabschnitts alternierend angeordnet sind. Dies kann zu besonders hohen Spannungsdifferenzen zwischen benachbarten Windungen führen, so dass durch Feldauslöschung im Fernfeld das elektrische Feld ab einem gewissen Abstand von den Leiterabschnitten besonders stark reduziert sein kann.

Der erste Leiterabschnitt kann zwischen einem Startbereich und einem Endbereich gewickelt sein. Bevorzugt ist auch der zweite Leiterabschnitt zwischen dem Startbereich und dem Endbereich gewickelt, so dass der Startbereich einen gemeinsamen Startbereich und der Endbereich einen gemeinsamen Endbereich bilden. Bevorzugt überlappen sich Startbereich und Endbereich nicht.

Um eine Wicklung zwischen einem gemeinsamen Startbereich und einem gemeinsamen Endbereich zu ermöglichen ist es aufgrund der seriellen Verschaltung von erstem Leiterabschnitt und zweitem Leiterabschnitt erforderlich, dass ein Teilabschnitt des Leiters zu einem gemeinsamen Bereich zurückgeführt wird.

Um eine räumliche Trennung zu vermeiden kann es hierbei zweckmäßig sein, wenn sich der erste Leiterabschnitt und der zweite Leiterabschnitt teilweise kreuzen. Zur Verhinderung einer elektrischen Kontaktierung kann vorgesehen sein, dass der erste Leiterabschnitt und/oder der zweite Leiterabschnitt zumindest an dem Kreuzungspunkt oder an den Kreuzungspunkten isoliert ist oder dass eine sonstige Isolationsschicht zwischen den beiden Leiterabschnitten vorgesehen ist. Durch die gemeinsame Wicklung zwischen zwei Bereichen kann es zu einer Verschränkung der beiden Leiterabschnitte kommen, so dass es zu Auslöschungseffekten des elektrischen Feldes kommen kann.

Bevorzugt sind der erste Leiterabschnitt und der zweite Leiterabschnitt jeweils über Windungen zwischen dem gemeinsam Startbereich und dem gemeinsamen Endbereich gewickelt. Hierdurch kann erreicht werden, dass nicht nur kurze Leiterabschnitte ineinandergreifen, sondern ganze Windungen, so dass Feldauslöschungseffekt besonders effektiv auftreten können.

Bei einer bevorzugten Variante der Erfindung kann vorgesehen sein, dass der erste Leiterabschnitt und der zweite Leiterabschnitt jeweils über Windungen von einem Startbereich zu einem Endbereich gewickelt sind. Bevorzugt ist der erste Leiterabschnitt von dem Startbereich zu dem Endbereich gewickelt, sodann ist der Leiter wieder zurückgeführt zu dem Startbereich und von dort aus ist sodann der zweite Leiterabschnitt wieder zu dem Endbereich gewickelt. Bevorzugt wechseln sich Windungen des ersten Leiterabschnitts und Windungen des zweiten Leiterabschnitts zwischen dem Startbereich und dem Endbereich ab.

Bei einer alternativen Variante der Erfindung kann vorgesehen sein, dass der erste Leiterabschnitt über Windungen von einem Startbereich zu einem Endbereich gewickelt ist und dass der zweite Leiterabschnitt über Windungen von dem Endbereich zu dem Startbereich gewickelt ist. Anders als bei der zuvor beschriebenen Variante ist es daher nicht erforderlich, zunächst eine Rückführung zu dem Startbereich vorzusehen, da die Rückführung durch die Rückwicklung erfolgen kann. Diese zweite Variante kann daher geringere ungewünschte Stromabschnitte aufweisen, was sich vorteilhaft auf die Stromverteilung und Effizienz der Magnetspule auswirken kann.

Bei einer weiteren vorteilhaften Ausgestaltung der Erfindung kann vorgesehen sein, dass der erste Leiterabschnitt helikal gewickelt ist. Eine helikale Wicklung kann auch dadurch charakterisiert sein, dass es sich um eine schraubenförmige Wicklung handelt. Alternativ und zusätzlich kann vorgesehen sein, dass der zweite Leiterabschnitt helikal gewickelt ist. Besonders bevorzugt beschreiben der erste Leiterabschnitt und/oder der zweiten Leiterabschnitt jeweils eine ein Volumen umlaufende Kurve um eine Mantelfläche einer Spulengeometrie. Die Spulengeometrie kann beispielsweise zylinderförmig sein, sie kann allerdings auch eine beliebige andere Geometrie aufweisen.

Bei einer weiteren vorteilhaften Ausgestaltung der Magnetspule kann vorgesehen sein, dass der erste Leiterabschnitt eine spiralförmige Wicklung aufweist. Bevorzugt ist die Spiralwicklung um ein Spiralzentrum gewickelt. Alternativ oder zusätzlich kann vorgesehen sein, dass der zweite Leiterabschnitt eine Spiralwicklung, vorzugsweise um ein Spiralzentrum, aufweist. Besonders bevorzugt beschreiben der erste und/oder der zweite Leiterabschnitt eine Kurve auf einer Mantelfläche einer Spulengeometrie. Der erste und/oder der zweite Leiterabschnitt können beispielsweise eine Kurve auf einer Mantelfläche eines Zylinders beschreiben oder eine Kurve in einer Ebene. Die Spulengeometrie kann allerdings auch eine beliebige andere Geometrie als eine zylinderförmige oder ebene Geometrie einnehmen.

Im Rahmen dieser Erfindung wird daher unterschieden zwischen einer helikalen Wicklung und eine Spiralwicklung. Eine helikale Wicklung kann auch dadurch charakterisiert sein, dass sich Windungen schraubenförmig einander anschließen. Eine Spiralwicklung kann auch dadurch charakterisiert sein, dass sich anschließende Windungen auf ein gemeinsames Spiralzentrum zu oder von diesem weg einander anschließen und dass daher einzelne Windungen andere Windungen auf einer Mantelfläche umlaufen.

Es kann vorgesehen sein, dass der erste Leiterabschnitt und/oder der zweite Leiterabschnitt auf einem Träger gewickelt ist oder sind. Der Träger kann beispielsweise zylinderförmig oder eben ausgebildet sein. Der Träger kann aber auch eine beliebige andere Geometrie aufweisen. Bevorzugt ist der Träger aus einem isolierenden Material ausgebildet. Der Träger kann hierbei so ausgebildet sein, dass der Magnetspule eine Formstabilität verschafft wird.

Bei einer weiteren vorteilhaften Ausgestaltung der Magnetspule kann vorgesehen sein, dass zumindest eine Windung, vorzugsweise mehrere oder sogar alle Windungen, des ersten Leiterabschnitts den zweiten Leiterabschnitt mehr als einmal kreuzt. Besonders bevorzugt kreuzt die eine Windung oder die mehreren Windungen den zweiten Leiterabschnitt jeweils genau zweimal. Weiter bevorzugt kreuzen Windungen des ersten Leiterabschnitts jeweils mehr als eine Windung des zweiten Leiterabschnitts. Durch das Kreuzen des ersten Leiterabschnitts und des zweiten Leiterabschnitts kann erreicht werden, dass diese ineinandergreifen, wodurch eine Feldauslöschung des elektrischen Feldes begünstigt werden kann.

Bei einer weiteren vorteilhaften Ausgestaltung der Magnetspule kann vorgesehen sein, dass die Windungen des ersten Leiterabschnitts und die Windungen des zweiten Leiterabschnitts im Vergleich zu einer nicht-überlappenden Vergleichsanordnung umgeordnet sind. Bei der Vergleichsanordnung handelt es sich bevorzugt um eine spiralförmig oder helikal fortlaufende Anordnung von Windungen. Bevorzugt bildet die Vergleichsanordnung somit eine standardmäßige helikale oder spiralförmige Wicklung, wobei die gesamte Wicklung gedanklich in zwei Bereiche, in einen ersten Leiterabschnitt und in einen zweiten Leiterabschnitt aufgeteilt wird, welche jeweils für sich eine nicht-überlappende, insbesondere spiralförmig oder helikal fortlaufende, Wicklung bilden und zugleich auch zusammen eine derartige Wicklung bilden.

Bei einer vorteilhaften Ausgestaltung kann vorgesehen sein, dass die umgeordneten Windungen jeweils einen gleichen Stromsinn aufweisen wie die entsprechenden Windungen der Vergleichsanordnung. Hierbei ist zu bemerken, dass der Strom selbstverständlich in eine Richtung oder in die andere Richtung fließen kann, je nachdem, ob eine positive oder negative Spannung zwischen dem Anfang des ersten Leiterabschnitts und dem Ende des zweiten Leiteranschnitts angelegt wird. Entscheidend ist allerdings, dass aufgrund der seriellen Anordnung bei Anliegen einer bestimmten Spannung durch die Windungen eine Stromrichtung vorgegeben ist. Diese Stromrichtung wird durch die Umordnung beibehalten. In diesem Sinn weisen sich entsprechende Windungen einen gleichen Stromsinn auf. Der Stromsinn kann von einer zwischen zwei stromtechnisch entfernten Enden des ersten und zweiten Leitungsabschnitts anliegenden Spannung vorgegeben sein.

Hierbei ist die einer umgeordneten Windung entsprechende Windung der Vergleichsanordnung diejenige, welche innerhalb der Wicklung zwar nicht zwingend schaltungstechnisch, jedoch räumlich die gleiche Position wie die umgeordnete Windung hat. Ist beispielsweise die Vergleichsanordnung durch die Windungen 1 bis N des ersten Leiterabschnitts und die Windungen N+1 bis 2N des zweiten Leiterabschnitts gegeben und erfolgt die Umordnung dadurch, dass die umgeordneten Windungen die Reihenfolge 1, N+1, 2, N+2, ..., N, 2N erhalten, so entspricht die erste Windung der umgeordneten Anordnung der Windung 1, die zweite Windung der umgeordneten Anordnung der Windung N+1, die dritte Windung der umgeordneten Anordnung der Windung 2, die vierte Windung der umgeordneten Anordnung der Windung N+2 usw.

Bei einer weiteren vorteilhaften Ausgestaltung der Magnetspule kann vorgesehen sein, dass die umgeordneten Windungen jeweils einen Spulenabschnitt bilden, der mit einer entsprechenden Windung der Vergleichsanordnung räumlich übereinstimmt. Diese bevorzugte Variante sieht daher vor, dass durch die Umordnung der Windungen die Stromverteilung im Wesentlichen unverändert bleibt, da bis auf die Verbindungen der Windungen untereinander die Leiterverteilung unverändert bleibt. Die Verbindungen der Windungen untereinander sind für die Erzeugung des Magnetfeldes von untergeordneter Rolle, da hierdurch Feldkomponenten erzeugt werden, die lediglich einen marginalen Einfluss auf die für die räumliche Kodierung verantwortliche Magnetfeldkomponente haben. Außerdem können die Verbindungen so designt werden, dass es zu einer gegenseitigen Aufhebung von Magnetfeldbeiträgen kommt. Daher kann erreicht werden, dass das von den beiden Leiterabschnitten erzeugt Magnetfeld durch die Umordnung nicht oder zumindest nicht wesentlich verändert wird. Eine unwesentliche Veränderung des Magnetfeldes liegt vor, wenn die Ortskodierung von MRT-Signalen nicht gestört wird, insbesondere nicht so, dass sich dies negativ auf die Qualität der durch einen MR-Messung gemessenen Information auswirken würde.

Bevorzugt ist vorgesehen, dass die Windungen so umgeordnet sind, dass ein von den beiden Leiterabschnitten erzeugtes konservatives elektrisches Feld reduziert wird. Besonders bevorzugt wird das elektrische Feld durch die Umordnung minimiert. Eine optimale Umordnung kann beispielsweise mittels eines Optimierungsverfahrens computergestützt berechnet werden. Das Minimum kann sich hierbei auf ein geeignetes Maß beziehen. Die Reduktion des erzeugten konservativen elektrischen Feldes kann zu einer Reduktion der Gefahr einer peripheren Nervenstimulation führen und kann daher vorteilhaft sein.

Bei einer alternativen bevorzugten Variante ist vorgesehen, dass die Windungen so umgeordnet sind, dass ein von den beiden Leiterabschnitten insgesamt erzeugtes elektrisches Feld reduziert wird. Bevorzugt wird das elektrische Feld nicht nur reduziert, sondern darüber hinaus auch minimiert. Diese Variante kann besonders vorteilhaft sein, da die Stimulation peripherer Nerven sowohl von dem konservativen elektrischen Feld bewirkt werden kann wie auch von dem elektrischen Begleitfeld, welches bei der Erzeugung des magnetischen Magnetfeldes auftreten kann. Das insgesamt erzeugte elektrische Feld ist daher durch die Resultierende dieser beiden Felder gegeben.

Die Erfindung wird nun anhand einiger weniger Ausführungsbeispiele näher beschrieben, ist jedoch nicht auf diese wenigen Ausführungsbeispiele beschränkt. Weitere Erfindungsvarianten und Ausführungsbeispiele ergeben sich durch Kombination der Merkmale einzelner oder mehrerer Schutzansprüche untereinander und/oder mit einzelnen oder mehreren Merkmalen der Ausführungsbeispiele und/oder der zuvor beschriebenen Varianten erfindungsgemäßer Ausgestaltungen der Erfindung, sofern dadurch der durch die Ansprüche definierte Schutzumfang nicht verlassen wird.

Es zeigt:
- Fig. 1: in schematischer Form Windungen einer Magnetspule mit elektrischen Anschlüssen,
- Fig. 2: eine Verschaltung von Windungen gemäß dem Stand der Technik,
- Fig. 3: ein erstes Ausführungsbeispiel einer erfindungsgemäßen Magnetspule,
- Fig. 4: ein zweites Ausführungsbeispiel einer erfindungsgemäßen Magnetspule.
- Fig. 5: eine Verschaltung von spiralförmigen Windungen in Übereinstimmung mit Fig. 2,
- Fig. 6: eine Verschaltung von spiralförmigen Windungen in Übereinstimmung mit Fig. 3,
- Fig. 7: eine Verschaltung von spiralförmigen Windungen in Übereinstimmung mit Fig. 4,
- Fig. 8: eine Z-Gradientenspule mit Angabe eines möglichen Verschaltungsbereichs,
- Fig. 9: eine X- oder Y-Gradientenspule mit Angabe eines möglichen Verschaltungsbereichs,
- Fig. 10: ein MR-Gerät mit einer erfindungsgemäßen Magnetspule.

Bei der nachfolgenden Beschreibung verschiedener Ausführungsbeispiele der Erfindung erhalten in ihrer Funktion übereinstimmende Elemente auch bei abweichender Gestaltung der Formgebung übereinstimmenden Bezugszahlen.

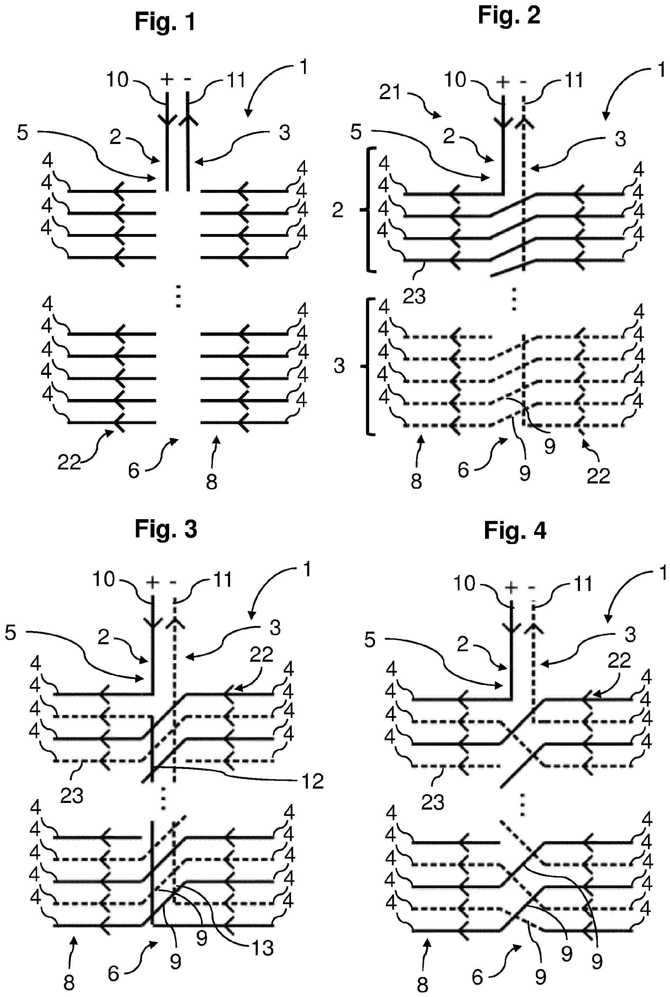

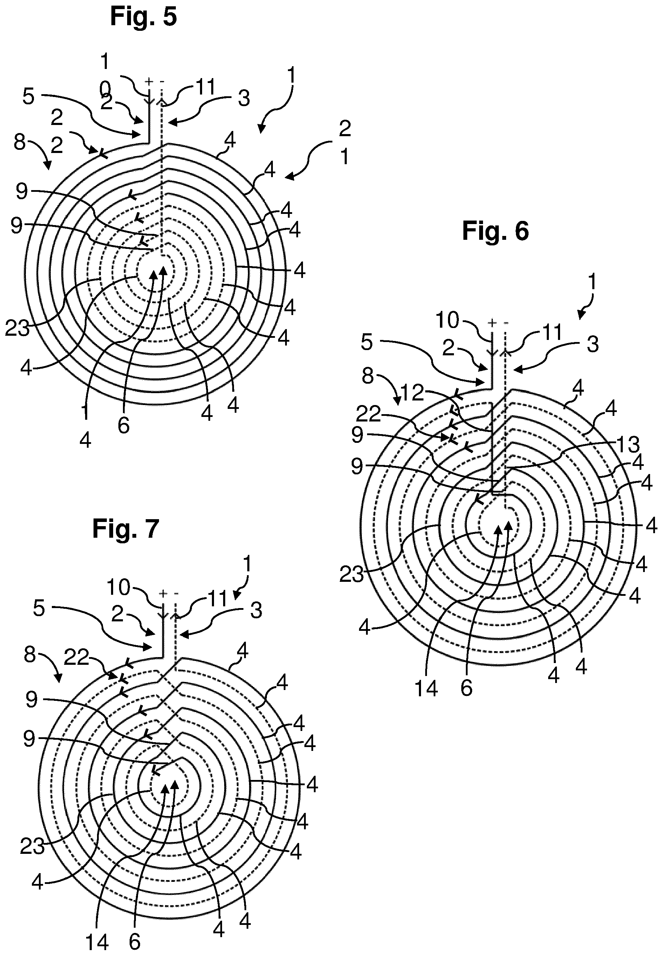

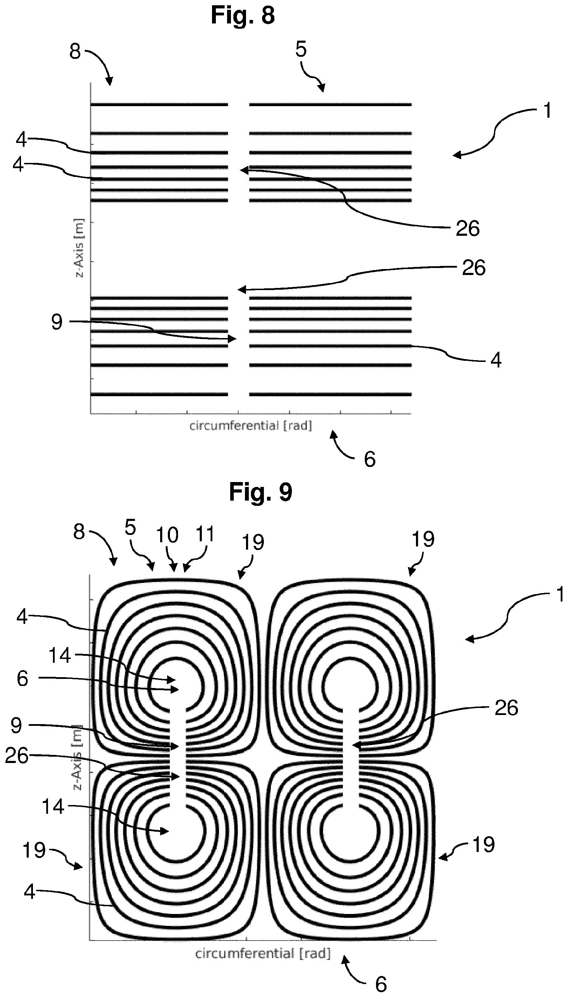

Fig. 1 bis Fig. 9 zeigen Magnetspulen 1. Während bei Fig. 1, Fig. 8 und Fig. 9 lediglich die einzelnen Windungen 4 dargestellt sind, sind bei Fig. 2 bis Fig. 7 auch die Verbindungen der seriell miteinander verschalteten Windungen 4 konkret angegeben. Die in Fig. 2 bis Fig. 4 gezeigten Magnetspulen 1 zeigen verschiedene Verschaltungsmuster der Windungen 4. Fig. 5 bis Fig. 7, die in ihrer Reihenfolge den Verschaltungsmustern gemäß Fig. 2 bis Fig. 4 entsprechen, zeigen als Beispiel jeweils eine spiralförmige Wicklung 8 einer Magnetspule 1. Fig. 8 zeigt eine als Z-Gradientenspule ausgebildete Magnetspule 1. Fig. 9 zeigt eine als X- bzw. Y-Gradientenspule ausgebildete Magnetspule 1.

Fig. 1 zeigt eine als Gradientenspule ausgebildete Magnetspule 1 in schematischer Ansicht. Die Magnetspule 1 hat eine Vielzahl von Windungen 4.

Bei einer Z-Gradientenspule 1 laufen die Windungen 4 um einen zylinderförmigen Träger herum, vgl. auch Fig. 8. Bei einer X-Gradientenspule 1 sind die Windungen 4 spiralförmig gewickelt um ein gemeinsames Spiralzentrum 14, vgl. auch Fig. 9. Andere Arten von Wicklungen 8 sind möglich.

In Fig. 1 ist gezeigt, dass der von einer Spannung an den Anschlussleitungen 10, 11 erzeugte Stromsinn 22 der Windungen 4 jeweils gleichgerichtet ist. Der Stromsinn 22 ist durch Pfeile angedeutet. Bei umgekehrter Polung der Anschlussleitungen 10, 11 ist der Stromsinn 22 umgekehrt. In Fig. 5 bis Fig. 7 ist aus Gründen der Übersichtlichkeit der Stromsinn 22 nicht für alle Windungen 4 explizit eingezeichnet.

Nicht dargestellt sind in Fig. 1 die Verbindungen zwischen einzelnen Windungen 4. Diese Verbindungen der Windungen 4 bzw. Verschaltungen der Windungen 4 können variieren und zu unterschiedlichen Ausgestaltungen der Magnetspule 1 führen.

Die Magnetspule 1 weist einen ersten Leiterabschnitt 2 und einen zweiten Leiterabschnitt 3 auf. Der zweite Leiterabschnitt 3 ist seriell mit dem ersten Leiterabschnitt 2 verschaltet.

In den in den Zeichnungen gezeigten Ausführungsbeispielen handelt es sich bei dem ersten Leiterabschnitt 2 um einen Drahtabschnitt, an den sich ein weiterer Drahtabschnitt, hier der zweite Leiterabschnitt 3, anschließt. In den in den Zeichnungen gezeigten Ausführungsbeispielen bilden daher der erster Leiterabschnitt 2 und der zweite Leiterabschnitt 3 einen gemeinsamen Draht.

Je nach Verschaltung gehören die einzelnen Windungen 4 entweder zu dem ersten Leiterabschnitt 2 oder zu dem zweiten Leiterabschnitt 3.

Der erste Leiterabschnitt 2 und der zweite Leiterabschnitt 3 sind zwischen einem Startbereich 5 und einem Endbereich 6 gewickelt.

Fig. 2 und Fig. 5 zeigen Magnetspulen 1, wie sie aus dem Stand der Technik bekannt ist. Die Windungen 4 sind hierbei so miteinander verbunden, dass jeweils angrenzende Windungen 4 miteinander verschaltet sind. Das dargestellte Wicklungsmuster kann sich beispielsweise dadurch ergeben, indem eine Spiralwicklung 8 von außen nach innen erfolgt und sodann eine Rückführleitung 12 von einem Spiralzentrum 14, welches am Endbereich 6 gelegen ist, wieder zurückgeführt wird.

Hierbei ist bei einer spiralförmigen Wicklung 8 der erste Leitungsabschnitt 2 durch die äußeren Windungen gegeben und der zweite Leiterabschnitt 3 durch die angrenzenden inneren Windungen. Bei einer Z-Gradientenspule 1 erfolgt die Wicklung 8, indem der Leiter Windung für Windung in axialer Richtung helikal fortlaufend, jedoch nicht äquidistant, sondern nach einem geeigneten Muster gewickelt wird, vgl. auch Fig. 8.

Die verbindenden Stufen 9, von denen aus Gründen der Übersichtlichkeit lediglich zwei explizit mit einer Bezugsziffer versehen sind, können vorhanden sein, es kann sich jedoch auch um eine stufenlose gleichmäßige spiral-und/oder schraubenförmige Wicklung 8 handeln.

Die in Fig. 2 gezeigte Anordnung von Windungen 4 zeigt eine nicht-überlappende, spiralförmig-fortlaufende oder helikalfortlaufende Vergleichsanordnung 21. Ein Beispiel einer spiralförmig-fortlaufenden Vergleichsanordnung 21 ist in Fig. 5 dargestellt. In der Praxis weichen die Windungen 4 üblicherweise von einer kreisförmigen Geometrie ab. Bekannte Wicklungsmuster sind beispielsweise dem Fachmann bekannt von handelsüblichen X- oder Y-Gradientenspulen. Hier sind insgesamt vier spiralförmige Wicklungen 8 auf einer zylinderförmigen Mantelfläche miteinander verschaltet, üblicherweise seriell. Eine derartige X- oder Y-Gradientenspule zeigt Fig. 8. X- und Y-Gradientenspulen können insbesondere bei zylinderförmiger Bauweise bis auf geringe Unterschiede, insbesondere infolge unterschiedlicher Durchmesser, gleich ausgebildet sein, wobei die Y-Gradientenspule gegenüber der X-Gradientenspule um 90° verdreht ist.

Fig. 3 zeigt eine Magnetspule 1 eines ersten erfindungsgemäßen Ausführungsbeispiels. Fig. 5 zeigt schematisch eine spiralförmige Magnetspule 1, deren Verschaltung der Magnetspule 1 aus Fig. 3 entspricht. Bei dem in Fig. 3 und Fig. 6 gezeigten Ausführungsbeispielen sind die Windungen 4 gegenüber der in Fig. 2 gezeigten Vergleichsanordnung 21 umgeordnet. Die Windungen 4 selbst weisen jeweils den gleichen Stromsinn 22 auf und befinden sich exakt an dem Ort wie die in Fig. 2 gezeigten Windungen 4. Lediglich die Verschaltung der Windungen 4 ist anders, so dass der erste Leiterabschnitt 2 und der zweite Leiterabschnitt 3, jeweils durch andere Windungen 4 gebildet sind als die Leiterabschnitte 2, 3 der in Fig. 2 gezeigten Vergleichsanordnung 21.

In dem in Fig. 3 gezeigten Ausführungsbeispiel verlaufen sowohl der erste Leiterabschnitt 2 wie auch der zweite Leiterabschnitt 3 von einem gemeinsamen Startbereich 5 zu einem gemeinsamen Endbereich 6. Die einzelnen Leiterabschnitte 2 und 3 sind hierbei spiralförmig oder schraubenförmig, im Vergleich zu Fig. 2 allerdings mit jeweils doppeltem Windungsabstand gewickelt. Hierbei ist die von dem zweiten Leiterabschnitt 3 gebildete Wicklung 8 versetzt gegenüber der von dem ersten Leiterabschnitt 2 gebildeten Wicklung 8. Im Ergebnis wechseln sich daher Windungen 4 des ersten Leiterabschnitts 2 mit Windungen 4 des zweiten Leiterabschnitts 3 alternierend ab.

Der Strom fließt hierbei wie folgt. Über eine erste Anschlussleitung 10 oder zunächst zu einer ersten Windung 4. Nach einem Umlauf fließt der Strom durch die in ihrer Position übernächsten Windung 4. Nach Durchlauf durch die Windung 4 fließt der Strom sodann sukzessive in den jeweils übernächsten Windungen 4 bis die letzte Windung 4 erreicht ist. Am Endbereich 6 angelangt, wird der Strom sodann zurückgeführt über eine Rückführleitung 12 zum Startbereich 5, wo er entlang der bezogen auf ihre Position zweiten Windung 4, die den Anfang des zweiten Leiterabschnitts 3 bildet, umläuft. Nach jedem Umlauf fließt der Strom sodann in der jeweils übernächsten Windung 4 weiter, bis der Endbereich 6 erneut erreicht ist, von wo eine weitere Rückführleitung 13 wieder zum Startbereich 5 geführt wird, welche sodann in die Anschlussleitung 11 mündet. Wird eine entgegengesetzte Spannung an den Anschlussleitungen 10, 11 angelegt, so fließt der Strom genau in die entgegengesetzte Richtung.

In einem alternativen Ausführungsbeispiel wird die Rückführleitung 13 nicht zu dem Startbereich 5 zurückgeführt, sondern zu einem anderen Bereich, an dem sich ein weiterer Leitungsabschnitt mit einer weiteren Wicklung 8 anschließend kann.

In Fig. 4 ist ein weiteres erfindungsgemäßes Ausführungsbeispiel einer Magnetspule 1 gezeigt. Fig. 6 zeigt schematisch eine spiralförmige Magnetspule 1, deren Verschaltung der Magnetspule 1 aus Fig. 4 entspricht. Auch in den in Fig. 4 und Fig. 7 gezeigten Ausführungsbeispielen wechseln sich Windungen 4 des ersten Leiterabschnitts 2 und Windungen 4 des zweiten Leiterabschnitts 3 alternierend ab.

Auch bei den in Fig. 4 und Fig. 7 gezeigten Ausführungsbeispielen ist der Stromsinn 22 der einzelnen Windungen 4 entsprechend der in Fig. 2 gezeigten Vergleichsanordnung 21 ausgebildet. Auch bilden die umgeordneten Windungen 4 jeweils einen Spulenabschnitt 23, der mit einer entsprechenden Windung 4 der Vergleichsanordnung 21 räumlich übereinstimmt. Allerdings ist in Fig. 4/Fig. 7 die Verschaltung anders als in Fig. 3/Fig. 6. In Fig. 2 bis Fig. 4 und in Fig. 5 bis Fig. 7 ist zur besseren Übersicht lediglich ein Spulenabschnitt 23 explizit mit einer Bezugsziffer versehen. Entsprechende Spulenabschnitte 23 werden von den anderen Windungen 4 gebildet.

Praktisch betrachtet wird in Fig. 3/Fig. 6 zunächst von außen nach innen gewickelt, sodann wird die Leitung wieder zurückgeholt zum Startbereich 5 und dann wird für den zweiten Leiterabschnitt 3 wiederum von außen nach innen gewickelt. Dies ist bei Fig. 4/Fig. 7 anders. Hier wird zunächst vom Startbereich 5 aus nach innen gewickelt zum Endbereich 6 und sodann wird wieder zurückgewickelt zum Startbereich 5.

Der erste Leiterabschnitt 2 stimmt in den in Fig. 3/Fig. 6 und Fig. 4/Fig.7 gezeigten Ausführungsbeispielen zwischen dem Startbereich 5 und dem Endbereich 6 miteinander überein. Der zweite Leiterabschnitt 3 beginnt in Fig. 4/Fig. 7 allerdings nicht am Startbereich 5, sondern am Endbereich 6, von wo aus der Stromfluss zur jeweils übernächsten Windung 4 geführt wird, bis der Startbereich 5 wieder erreicht ist.

Die Spannungsdifferenzen zwischen den einzelnen Windungen 4 unterscheiden sich daher zwischen den beiden erfindungsgemäßen Ausgestaltungen. Während bei Fig. 3/Fig. 6 die Spannungsdifferenzen zwischen benachbarten Windungen 4 gleichbleibend hoch sind, sind sie bei dem in Fig. 4/Fig. 7 gezeigten Ausführungsbeispiel in der Nähe des Startbereich 5 sehr hoch und höher als im Bereich des Endbereichs 6, insgesamt jedoch auch höher als bei der Vergleichsanordnung 21 gemäß Fig. 2/Fig. 5.

Die beiden erfindungsgemäßen Ausführungsbeispiele unterscheiden sich von der Vergleichsanordnung 21 in Fig. 2 gemeinsam dadurch, dass Windungen 4 des einen Leiterabschnitts 2, 3 jeweils zwischen benachbarten Windungen 4 des jeweils anderen Leiterabschnitts 2, 3 angeordnet sind. Auch ist erkennbar, dass die Windungen 4 den von dem ersten Leiterabschnitt 2 und dem zweiten Leiterabschnitt 3 gebildeten Leiter jeweils an zwei Punkten kreuzen, während dies bei der Vergleichsanordnung 21 gemäß Fig. 2/Fig. 5 jeweils nur an einer Stelle erfolgt.

In Fig. 4/Fig. 7 kreuzen Windungen 4 des ersten Leiterabschnitts 2 Windungen 4 des zweiten Leiterabschnitts 3.

Bei den Ausführungsbeispielen gemäß Fig. 3/Fig. 6 und Fig. 4/Fig. 7 liegt jeweils eine Umordnung von Windungen 4 gegenüber der in Fig. 2/Fig. 5 gezeigten Vergleichsanordnung 21 vor, welche zu einer Reduktion des von den beiden Leiterabschnitt 2 und 3 erzeugten konservativen elektrischen Feldes führt sowie zu einer Reduktion einer Resultierenden aus konservativem elektrischen Feld und dem elektrischen Feld, welches als Begleitfeld zudem von der Magnetspule 1 erzeugten Magnetfeld erzeugt wird.

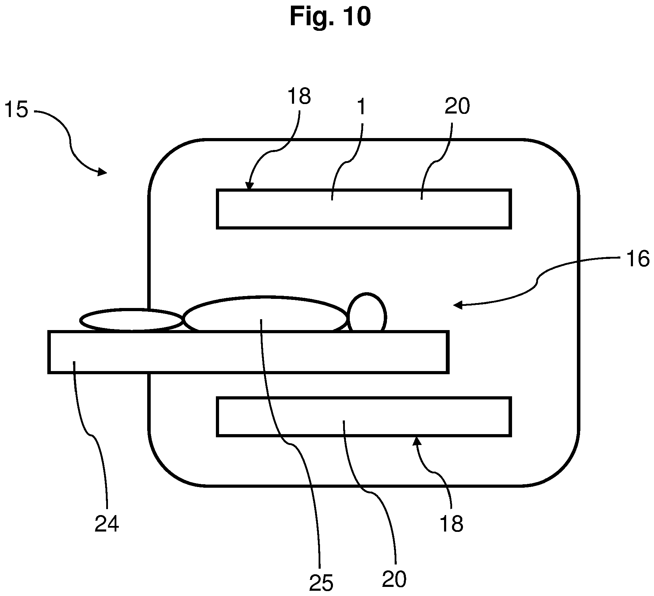

Ein Beispiel einer als Z-Gradientenspule ausgebildeten Magnetspule 1 mit zylinderförmiger Spulengeometrie ist in Fig. 8 dargestellt. Die Zeichnung zeigt in Polarkoordinaten die Windungen 4 der Spulenwicklung 8 der Magnetspule 1 ohne deren Verschaltung. Entlang der z-Achse ("z-Axis") setzt sich die Magnetspule 1 schraubenförmig fort. Hierbei umschließt die Magnetspule 1 ein Volumen 16 (vgl. Fig. 10), wobei die

Windungen 4 den Spulenkörper entlang der Umlaufrichtung der Magnetspule 1 umlaufen. Die Verschaltung der Windungen 4 erfolgt in einem Verschaltungsbereich 26 und kann beispielsweise über Stufen 9 erfolgen, die nicht explizit eingezeichnet sind. Hierbei kann die Verschaltung auf unterschiedliche Weise erfolgen wie beispielsweise entsprechend der in Fig. 2 bis Fig. 7 dargestellten und/oder in der zuvor beschriebenen Weise.

Ein Beispiel einer als X- bzw. Y-Gradientenspule ausgebildeten Magnetspule 1 mit zylinderförmiger Spulengeometrie ist in Fig. 9 in Polarkoordinaten dargestellt. Die Magnetspule ist entlang der z-Achse ("z-Axis") offen und entlang der Umlaufrichtung ("cirumferential") geschlossen. Eine derartige Spulengeometrie ist beispielsweise in Fig. 10 gezeigt.

Die X- bzw. Y-Gradientenspule hat insgesamt vier Spiralzentren 14, um die die Magnetspule 1 spiralförmig gewickelt ist.

Dargestellt sind lediglich die Windungen 4. Deren Verschaltung ist nicht explizit dargestellt. Die Verschaltung der Windungen 4 erfolgt in einem Verschaltungsbereich 26 und kann beispielsweise über Stufen 9 erfolgen, die nicht explizit eingezeichnet sind.

Hierbei kann die Verschaltung auf unterschiedliche Weise erfolgen wie beispielsweise für jede Spiralwicklung 8 entsprechend der in Fig. 2 bis Fig. 7 dargestellten und zuvor beschriebenen Weise. In diesem Zusammenhang kann die in Fig. 5 bis Fig. 7 gezeigte Leiteranordnung auch ein Spiralsegment 19 bilden. Das Spiralsegment 19 kann seriell oder auch parallel an andere Spiralsegmente 19 angeschlossen sein.

Bei dem in Fig. 9 gezeigten Ausführungsbeispiel kann beispielsweise die erste Anschlussleitung 10 an dem angezeigten Ort entlang der z-Achse zu dem in der Zeichnung links oben gelegenen Spiralsegment 19 in der Weise gelegt sein, wie in Fig. 5 bis Fig. 7 dargestellt. Sodann kann die Spiralwicklung 8 erfolgen wie beispielsweise in Fig. 5 bis Fig. 7 dargestellt. Während sich in Fig. 5 bis Fig. 7 jedoch an die Wicklung 8 die zweite Anschlussleitung 11 nach oben zurückgeführt wird, werden bei einer X- bzw. Y-Gradientenspule üblicherweise zunächst die übrigen Spiralsegmente 19 hintereinander seriell angeschlossen, wobei zum Schluss die Anschlussleitung 11 im Wesentlichen parallel zu der Anschlussleitung 10 aus der Magnetspule hinausgeführt wird.

Die Verschaltungsreihenfolge der Spulensegmente 19 kann frei gewählt werden. Im Rahmen dieser Erfindung ist eine Verschaltung bevorzugt, bei der das elektrische Feld minimiert oder zumindest reduziert ist gegenüber einer Verschaltung von aktuell handelsüblichen Gradientenspulen.

In einer bevorzugten Variante wird bereits vor Beendigung einer Wicklung 8 eines Spiralsegments 19 eine Windung 4 eines anderen Spiralsegments 19 verschaltet. Dies ist zwischen benachbarten Spiralsegmenten 19 unproblematisch, da eine intersegmentale Verschaltung durch relativ kurze Verschaltungsleiter erreichbar ist. Eine Verschaltung zu weiter entfernt liegenden Spiralsegmenten 19 ist möglich, wobei die Vorteile mit den möglicherweise entstehenden Effizienzverlusten abzuwägen sind.

In Fig. 9 ist ein Verschaltungsbereich 26 vorgesehen, der auch eine Verschaltung von sich in z-Richtung anschließenden Spiralsegmenten zulässt. Sollte eine Verschaltung von sich in Umlaufrichtung anschließenden Spiralsegmenten 19 gewünscht sein, kann auch ein in Umlaufrichtung ausgebildeter Verschaltungsbereich vorgesehen sein.

Fig. 10 zeigt ein MR-Gerät 15. Das MR-Gerät 15 hat einen Patiententisch 24, auf dem ein Messobjekt wie etwa ein Proband 25 zur Messung gelegt werden kann. Das MR-Gerät 15 ist fachüblich ausgebildet und weist die fachüblichen Komponenten wie insbesondere einen Hauptmagneten, ein HF-System und eine Datenauswertungseinheit auf. Explizit dargestellt ist lediglich eine als Gradientenspule ausgebildete Magnetspule 1. Die Magnetspule 1 hat einen zylinderförmigen Träger 20, der der Magnetspule 1 Formstabilität verleiht. Auf einer zylinderförmigen Mantelfläche 18 ist die Magnetspule 1 gewickelt. Diese kann wie zuvor beschrieben ausgebildet sein. Die Magnetspule 1 umschließt ein Volumen 16.

Zusammenfassend wird eine Erfindung beschrieben, bei der gegenüber vorbekannten Magnetspulen 1 Windungen 4 umgeordnet werden, so dass zumindest eine Windung 4 eines ersten Leiterabschnitts 2 zwischen zwei benachbarten Windungen 4 eines sich seriell anschließenden zweiten Leiterabschnitts 3 angeordnet ist. Durch diese Umordnung kann erreicht werden, dass das von der Magnetspule 1 erzeugte elektrische Feld gegenüber vorbekannten Magnetspulen 1 verändert ist, sodass die Gefahr einer Stimulation peripherer Nerven beim Betrieb der Magnetspule 1 reduziert werden kann.

### Bezugszeichenliste

- 1: Magnetspule
- 2: erster Leiterabschnitt
- 3: zweiter Leiterabschnitt
- 4: Windung
- 5: Startbereich
- 6: Endbereich
- 8: Wicklung
- 9: Stufe
- 10: erste Anschlussleitung
- 11: zweite Anschlussleitung
- 12: Rückführleitung
- 13: weitere Rückführleitung
- 14: Spiralzentrum
- 15: MR-Gerät
- 16: Volumen
- 18: Mantelfläche
- 19: Spiralsegment
- 20: Träger
- 21: Vergleichsanordnung
- 22: Stromsinn
- 23: Spulenabschnitt
- 24: Patiententisch
- 25: Proband
- 26: Verschaltungsbereich

## Patentansprüche

1. Magnetspule (1) für ein MR-Gerät (15) oder für einen Magnetpartikelbildgebungstomographen mit einem ersten Leiterabschnitt (2,3) und einem seriell an den ersten Leiterabschnitt (2,3) anschließenden zweiten Leiterabschnitt (2,3), wobei der erste und der zweite Leiterabschnitt (2,3) jeweils eine Mehrzahl von Windungen (4) aufweisen und wobei die Magnetspule eine Gradientenspule und/oder eine Shimspule ist, **dadurch gekennzeichnet, dass** mindestens eine Windung (4) des ersten Leiterabschnitts (2,3) zwischen zwei benachbarten Windungen (4) des zweiten Leiterabschnitts (2,3) angeordnet ist und dass der erste Leiterabschnitt (2,3) und der zweite Leiterabschnitt (2,3) Abschnitte eines Leiters bilden.

2. Magnetspule (1) nach dem vorangehenden Anspruch, **dadurch gekennzeichnet, dass** Windungen (4) des ersten Leiterabschnitts (2,3) und Windungen (4) des zweiten Leiterabschnitts (2,3) alternierend angeordnet sind.

3. Magnetspule (1) nach einem der vorangehenden Ansprüche, **dadurch gekennzeichnet, dass** der erste Leiterabschnitt (2,3) und der zweite Leiterabschnitt (2,3) jeweils, vorzugsweise über Windungen (4), zwischen einem gemeinsamen Startbereich (5) und einem gemeinsamen Endbereich (6) gewickelt sind.

4. Magnetspule (1) nach einem der vorangehenden Ansprüche, **dadurch gekennzeichnet, dass** der erste Leiterabschnitt (2,3) und der zweite Leiterabschnitt (2,3) jeweils über Windungen (4) von einem Startbereich (5) zu einem Endbereich (6) gewickelt sind.

5. Magnetspule (1) nach einem der vorangehenden Ansprüche, **dadurch gekennzeichnet, dass** der erste Leiterabschnitt (2,3) über Windungen (4) von einem Startbereich (5) zu einem Endbereich (6) gewickelt ist und dass der zweite Leiterabschnitt (2,3) über Windungen (4) von dem Endbereich (6) zu dem Startbereich (5) gewickelt ist.

6. Magnetspule (1) nach einem der vorangehenden Ansprüche, **dadurch gekennzeichnet, dass** der erste Leiterabschnitt (2,3) und/oder der zweite Leiterabschnitt (2,3) eine schraubenförmige Wicklung (8) aufweist/aufweisen, insbesondere wobei der erste Leiterabschnitt (2,3) und/oder der zweite Leiterabschnitt (2,3) eine ein Volumen (16) umlaufende Kurve um eine Mantelfläche (18) einer Spulengeometrie beschreibt/beschreiben.

7. Magnetspule (1) nach einem der vorangehenden Ansprüche, **dadurch gekennzeichnet, dass** der erste Leiterabschnitt (2,3) und/oder der zweite Leiterabschnitt (2,3) eine spiralförmige Wicklung (8) vorzugsweise um ein Spiralzentrum (14) aufweist/aufweisen, insbesondere wobei der erste Leiterabschnitt (2,3) und/oder der zweite Leiterabschnitt (2,3) eine Kurve auf einer Mantelfläche (18) einer Spulengeometrie beschreibt/beschreiben.

8. Magnetspule (1) nach einem der vorangehenden Ansprüche, **dadurch gekennzeichnet, dass** der erste Leiterabschnitt (2,3) und/oder der zweite Leiterabschnitt (2,3) auf einem vorzugsweise zylinderförmigen oder ebenen Träger (20) gewickelt ist/sind.

9. Magnetspule (1) nach einem der vorangehenden Ansprüche, **dadurch gekennzeichnet, dass** eine Windung (4), vorzugsweise mehrere oder alle Windungen (4), des ersten Leiterabschnitts (2,3) den zweiten Leiterabschnitt (2,3) mehr als einmal, vorzugsweise zweimal, kreuzt, insbesondere wobei Windungen (4) des ersten Leiterabschnitts (2,3) jeweils mehr als eine Windung (4) des zweiten Leiterabschnitts (2,3) kreuzen.

10. MR-Gerät (15) oder Magnetpartikelbildgebungstomograph mit einer Magnetspule (1) nach einem der vorangehenden Ansprüche.

## Claims

1. Solenoid coil (1) for an MR apparatus (15) or for a magnetic particle imaging tomograph, having a first conductor section (2, 3) and a second conductor section (2, 3) adjoining the first conductor section (2, 3) in series, wherein the first and the second conductor section (2, 3) each have a plurality of turns (4) and wherein the solenoid coil is a gradient coil and/or a shim coil,
**characterized in that** at least one turn (4) of the first conductor section (2, 3) is arranged between two adjacent turns (4) of the second conductor section (2, 3) and **in that** the first conductor section (2, 3) and the second conductor section (2, 3) form sections of a conductor.

2. Solenoid coil (1) according to the preceding claim, **characterized in that** turns (4) of the first conductor section (2, 3) and turns (4) of the second conductor section (2, 3) are arranged alternately.

3. Solenoid coil (1) according to one of the preceding claims, **characterized in that** the first conductor section (2, 3) and the second conductor section (2, 3) are each wound, preferably via turns (4), between a common start region (5) and a common end region (6).

4. Solenoid coil (1) according to one of the preceding claims, **characterized in that** the first conductor section (2, 3) and the second conductor section (2, 3) are each wound via turns (4) from a start region (5) to an end region (6).

5. Solenoid coil (1) according to one of the preceding claims, **characterized in that** the first conductor section (2, 3) is wound via turns (4) from a start region (5) to an end region (6) and **in that** the second conductor section (2, 3) is wound via turns (4) from the end region (6) to the start region (5).

6. Solenoid coil (1) according to one of the preceding claims, **characterized in that** the first conductor section (2, 3) and/or the second conductor section (2, 3) has/have a helical turn (8), in particular wherein the first conductor section (2, 3) and/or the second conductor section (2, 3) describes/describe a curve running around a volume (16) about a circumferential surface (18) of a coil geometry.

7. Solenoid coil (1) according to one of the preceding claims, **characterized in that** the first conductor section (2, 3) and/or the second conductor section (2, 3) has/have a spiral turn (8) preferably around a spiral center (14), in particular wherein the first conductor section (2, 3) and/or the second conductor section (2, 3) describes/describes a curve on a circumferential surface (18) of a coil geometry.

8. Solenoid coil (1) according to one of the preceding claims, **characterized in that** the first conductor section (2, 3) and/or the second conductor section (2, 3) is/are wound on a preferably cylindrical or flat carrier (20).

9. Solenoid coil (1) according to one of the preceding claims, **characterized in that** a turn (4), preferably several or all turns (4), of the first conductor section (2, 3) crosses the second conductor section (2, 3) more than once, preferably twice, in particular wherein turns (4) of the first conductor section (2, 3) each cross more than one turn (4) of the second conductor section (2, 3).

10. MR apparatus (15) or magnetic particle imaging tomograph comprising a magnetic coil (1) according to one of the preceding claims.

## Revendications

1. Bobine magnétique (1) pour un appareil de RM (15) ou pour un tomographe d'imagerie par particules magnétiques avec une première section de conducteur (2, 3) et une deuxième section de conducteur (2, 3) se raccordant en série à la première section de conducteur (2, 3), la première et la deuxième section de conducteur (2, 3) présentant chacun une pluralité de spires (4) et la bobine magnétique étant une bobine à gradient et/ou une bobine de correction, **caractérisée en ce qu'**au moins une spire (4) de la première section de conducteur (2, 3) est disposée entre deux spires (4) voisines de la deuxième section de conducteur (2, 3) et **en ce que** la première section de conducteur (2, 3) et la deuxième section de conducteur (2, 3) forment des sections d'un conducteur.

2. Bobine magnétique (1) selon la revendication précédente, **caractérisée en ce que** les spires (4) de la première section de conducteur (2, 3) et les spires (4) de la deuxième section de conducteur (2, 3) sont disposées en alternance.

3. Bobine magnétique (1) selon l'une des revendications précédentes, **caractérisée en ce que** la première section de conducteur (2, 3) et la deuxième section de conducteur (2, 3) sont enroulées chacune, de préférence au moyen de spires (4), entre une zone de départ commune (5) et une zone de fin commune (6).

4. Bobine magnétique (1) selon l'une des revendications précédentes, **caractérisée en ce que** la première section de conducteur (2, 3) et la deuxième section de conducteur (2, 3) sont enroulées chacune au moyen de spires (4) d'une zone de départ (5) à une zone de fin (6).

5. Bobine magnétique (1) selon l'une des revendications précédentes, **caractérisée en ce que** la première section de conducteur (2, 3) est enroulée au moyen de spires (4) d'une zone de départ (5) à une zone de fin (6) et **en ce que** la deuxième section de conducteur (2, 3) est enroulée au moyen de spires (4) de la zone de fin (6) à la zone de départ (5).

6. Bobine magnétique (1) selon l'une des revendications précédentes, **caractérisée en ce que** la première section de conducteur (2, 3) et/ou la deuxième section de conducteur (2, 3) présente/présentent un enroulement hélicoïdal (8), en particulier la première section de conducteur (2, 3) et/ou la deuxième section de conducteur (2, 3) décrivant une courbe entourant un volume (16) autour d'une surface d'enveloppe (18) d'une géométrie de bobine.

7. Bobine magnétique (1) selon l'une des revendications précédentes, **caractérisée en ce que** la première section de conducteur (2, 3) et/ou la deuxième section de conducteur (2, 3) présente/présentent un enroulement en spirale (8), de préférence autour d'un centre de spirale (14), en particulier la première section de conducteur (2, 3) et/ou la deuxième section de conducteur (2, 3) décrivant une courbe sur une surface d'enveloppe (18) d'une géométrie de bobine.

8. Bobine magnétique (1) selon l'une des revendications précédentes, **caractérisée en ce que** la première section de conducteur (2, 3) et/ou la deuxième section de conducteur (2, 3) est/sont enroulée(s) sur un support (20) de préférence cylindrique ou plan.

9. Bobine magnétique (1) selon l'une des revendications précédentes, **caractérisée en ce qu'**une spire (4), de préférence plusieurs ou toutes les spires (4), de la première section de conducteur (2, 3) croise la deuxième section de conducteur (2, 3) plus d'une fois, de préférence deux fois, en particulier des spires (4) de la première section de conducteur (2, 3) croisant chacune plus d'une spire (4) de la deuxième section de conducteur (2, 3).

10. Appareil de RM (15) ou tomographe d'imagerie par particules magnétiques doté d'une bobine magnétique (1) selon l'une des revendications précédentes.
